# EUROPEAN PATENT APPLICATION

(11) **EP 4 826 704 A1**
(43) Date of publication of application: **21.10.2026**
(21) Application number: 26171833.2
(22) Date of filing: 13.04.2026
(51) Int. Cl.: G09G 3/20, H03F 3/00, H03F 3/45, H03F 3/68

(54) **DUAL BUFFER CIRCUIT, GAMMA VOLTAGE GENERATION CIRCUIT HAVING THE SAME, AND DATA DRIVER CIRCUIT HAVING THE SAME**

(30) Priority: 14.04.2025 KR 20250048354
(71) Applicant: LX Semicon Co., Ltd., Daejeon 34027 (KR)
(72) Inventor: BACK, Hohyun, 34027 Daejeon (KR); SHIN, Kyungmin, 34027 Daejeon (KR)
(74) Representative: Goddar, Heinz J.

(57) **Abstract**

The present disclosure relates to a dual buffer circuit capable of eliminating an offset voltage. In the dual buffer circuit according to an embodiment, a first buffer circuit operates by alternating between a first sampling period during which a first offset voltage of a first operational amplifier is sampled and stored in a first capacitor and a first holding period during which the first offset voltage stored in the first capacitor is held, a second buffer circuit operates by alternating between a second sampling period during which a second offset voltage of a second operational amplifier is sampled and stored in a second capacitor and a second holding period during which the second offset voltage stored in the second capacitor is held, the first sampling period is entirely within the second holding period, and the second sampling period is entirely within the first holding period.

## Description

### CROSS-REFERENCE TO RELATED APPLICATION

This application claims the benefit of the Korean Patent Application No. 10-2025-0048354 filed on April 14, 2025.

### BACKGROUND

### Field of the Invention

The present disclosure relates to a dual buffer circuit, a gamma voltage generation circuit having the same, and a data driver circuit having the same.

### Discussion of the Related Art

A gamma voltage generation circuit built into a data driver circuit in a display device may receive a plurality of reference gamma voltages from a reference gamma voltage generation circuit and subdivide the plurality of reference gamma voltages through a resistor string to generate subdivided gamma voltages.

The gamma voltage generation circuit includes a plurality of buffer circuits each buffering and outputting a corresponding one of the plurality of reference gamma voltages. Each of the buffer circuits may include an operational amplifier, and the operational amplifier may have an offset voltage due to design and process deviations, etc.

Since the buffer circuit generates an input/output voltage difference due to the offset voltage, a method of removing the offset voltage is required.

To achieve low power consumption in the data driver circuit and the display device, the buffer circuit requires a method of reducing power consumption.

### SUMMARY

The present disclosure provides a dual buffer circuit capable of eliminating an offset voltage, a gamma voltage generation circuit having the same, and a data driver circuit having the same.

The present disclosure provides a dual buffer circuit capable of reducing power consumption, a gamma voltage generation circuit having the same, and a data driver circuit having the same.

A dual buffer circuit according to an embodiment of the present disclosure may include a first buffer circuit including a first operational amplifier that is connected between an input terminal and an output terminal and a first capacitor and a first switch section that are connected to the first operational amplifier and a second buffer circuit including a second operational amplifier that is connected between the input terminal and the output terminal and a second capacitor and a second switch section that are connected to the second operational amplifier, wherein the first buffer circuit may operate by alternating between a first sampling period during which a first offset voltage of the first operational amplifier is sampled and stored in the first capacitor, and a first holding period during which the first offset voltage stored in the first capacitor is held, the second buffer circuit may operate by alternating between a second sampling period during which a second offset voltage of the second operational amplifier is sampled and stored in on the second capacitor, and a second holding period during which the second offset voltage stored in the second capacitor is held, the first sampling period is entirely within the second holding period, and the second sampling period is entirely within the first holding period.

In the dual buffer circuit according to an embodiment of the present disclosure, in response to a disabled state of an auto-zero enable signal, one of the first and second buffer circuits may operate in a buffer mode, and the other may be turned off.

A gamma voltage generation circuit according to an embodiment of the present disclosure may include a gamma buffer section that includes a plurality of gamma buffers each buffering and outputting a corresponding one of a plurality of reference gamma voltages and a resistor string that divides the plurality of reference gamma voltages output from the gamma buffer section to output a plurality of gamma voltages, wherein each of the plurality of gamma buffers includes the dual buffer circuit.

A data driver circuit according to an embodiment of the present disclosure may include a gamma voltage generation circuit that divides a plurality of reference gamma voltages to output a plurality of gamma voltages and a digital-to-analog converter section that converts digital data into an analog data signal using the plurality of gamma voltages and outputs the converted analog data signal, wherein the gamma voltage generation circuit may include a gamma buffer section including a plurality of gamma buffers each buffering and outputting a corresponding one of the plurality of reference gamma voltages, and a resistor string that divides the plurality of reference gamma voltages output from the gamma buffer section to output the plurality of gamma voltages and each of the plurality of gamma buffers includes the dual buffer circuit.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is an exemplary diagram showing the configuration of a dual buffer circuit according to an embodiment of the present disclosure;
FIG. 2 is an exemplary diagram showing a switch controller connected to the dual buffer circuit according to an embodiment of the present disclosure;
FIG. 3 is a table illustrating switch operation states for each operation mode of the dual buffer circuit according to an embodiment of the present disclosure;
FIG. 4 is an exemplary diagram showing driving waveforms when the dual buffer circuit according to an embodiment illustrated in FIG. 1 operates in a dual auto-zero mode;
FIG. 5 is an exemplary diagram showing the operating state of a first horizontal period in the dual auto-zero mode of the dual buffer circuit according to an embodiment illustrated in FIG. 1;
FIG. 6 is an exemplary diagram showing the operating state of a second horizontal period in the dual auto-zero mode of the dual buffer circuit according to an embodiment illustrated in FIG. 1;
FIGS. 7A and 7B are equivalent circuit diagrams illustrating the operating state of a first sampling period of a first buffer circuit according to an embodiment of the present disclosure;
FIGS. 8A and 8B are equivalent circuit diagrams illustrating the operating state of a first holding period of the first buffer circuit according to an embodiment of the present disclosure;
FIG. 9 is an exemplary diagram showing a state in which the dual buffer circuit according to an embodiment of the present disclosure illustrated in FIG. 1 operates in a buffer mode;
FIG. 10 is a diagram illustrating driving waveforms of the dual buffer circuit illustrated in FIG. 9;
FIG. 11 is an exemplary diagram showing the internal configuration of the first buffer circuit according to an embodiment of the present disclosure;
FIGS. 12A and 12B are equivalent circuit diagrams showing the operating states of the sampling period and holding period of a buffer circuit according to a comparative example;
FIGS. 13A and 13B are equivalent circuit diagrams showing the operating states of the sampling period and holding period of a first buffer circuit of the dual buffer circuit according to an embodiment of the present disclosure;
FIG. 14 is an exemplary diagram showing the configuration of a gamma voltage generation circuit according to an embodiment of the present disclosure;
FIG. 15 is an exemplary diagram showing the configuration of a data driver circuit according to an embodiment of the present disclosure;
FIGS. 16A and 16B are exemplary diagrams showing the driving waveforms of a data driver circuit using a gamma voltage generation circuit according to a comparative example and an embodiment of the present disclosure; and
FIG. 17 is an exemplary diagram showing the configuration of a display device according to an embodiment of the present disclosure.

### DETAILED DESCRIPTION OF THE DISCLOSURE

Advantages and features of the present disclosure and the methods of achieving them will become clear by referring to the embodiments described in detail below together with the accompanying drawings. However, the present disclosure is not limited to the embodiments disclosed below, but may be implemented in various different forms, and these embodiments are provided merely to make the disclosure of the present disclosure complete and to fully inform a person having ordinary skill in the art to which the present disclosure pertains of the scope of the invention, and the present disclosure is defined only by the scope of the claims.

Throughout the specification, the same reference numerals refer to the same components. In addition, in describing the present disclosure, when it is determined that a detailed description of related known technology may unnecessarily obscure the gist of the present disclosure, such detailed description is omitted.

When expressions including terms such as "include," "have," and "comprise" are used in this specification, other components may be added unless "only" is used in such expressions. When a component is expressed in the singular, it includes cases where plural components are included unless specifically and explicitly stated otherwise.

In interpreting a component, it should be interpreted as including an error range even when there is no separate explicit description of the error range.

In the case of describing a positional relationship, for example, when the positional relationship between two parts is described as "on," "above," "below," "next to," or "adjacent to," there may be one or more other parts located between the two parts, unless, for example, "immediately," "directly," or "close to" is used.

In the case of describing a temporal relationship, for example, when a temporal sequence is described as "after," "following," "next," "before," etc., it may also include cases where it is not continuous, as long as "immediately" or "directly" is not used.

Although terms such as "first" and "second" are used to describe various components, these components are not limited by these terms. These terms are only used to distinguish one component from another. Therefore, a first component mentioned below may also be a second component within the technical scope of the present disclosure.

The term "at least one" should be understood to include all combinations that can be presented from one or more of related items. For example, the meaning of "at least one of a first item, a second item, and a third item" may mean not only each of the first item, the second item, or the third item, but also any combination of items that can be presented from two or more of the first item, the second item, and the third item.

The features of each of various embodiments of the present disclosure may be partially or entirely coupled to or combined with each other and may be technically interlocked and operated in various ways. Each embodiment may be independently implemented of the others or may be implemented together in an associated relationship.

Hereinafter, exemplary embodiments of the present disclosure will be described with reference to the attached drawings. The scale of the components shown in the drawings is different from the actual scale for convenience of description, and therefore is not limited to the scale shown in the drawings.

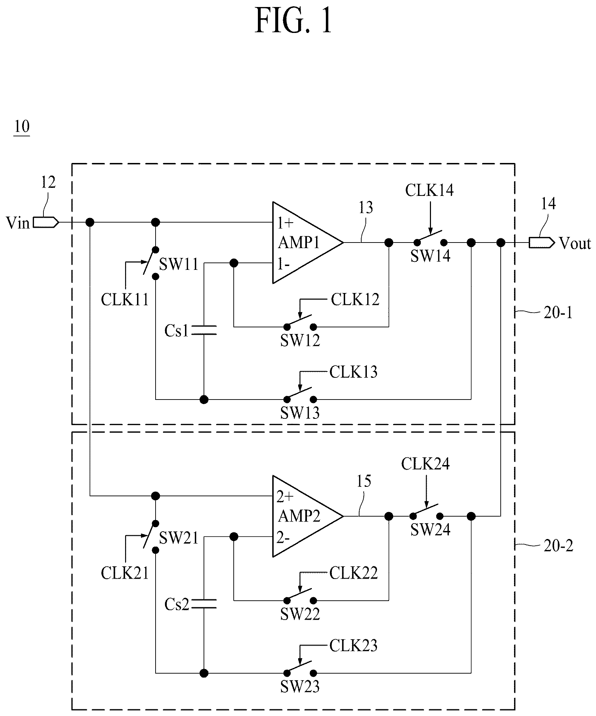

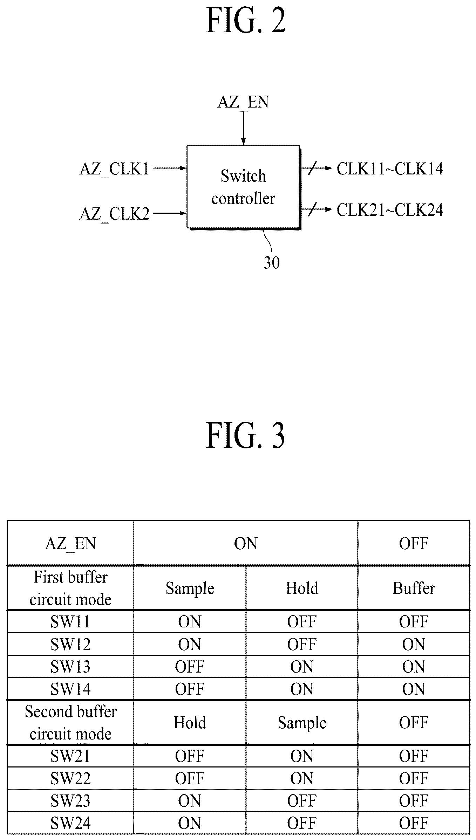

FIG. 1 is an exemplary diagram illustrating the configuration of a dual buffer circuit according to an embodiment of the present disclosure, FIG. 2 is an exemplary diagram illustrating a switch controller connected to the dual buffer circuit according to an embodiment of the present disclosure, and FIG. 3 is a table illustrating switch operating states for each operation mode of the dual buffer circuit according to an embodiment of the present disclosure.

Referring to FIG. 1, a dual buffer circuit 10 according to an embodiment may include first and second buffer circuits 20-1 and 20-2 that share an input terminal 12 and an output terminal 14.

The first buffer circuit 20-1 may include a first operational amplifier AMP1, eleventh to fourteenth switches SW11, SW12, SW13, and SW14, and a first capacitor Cs1. The eleventh to fourteenth switches SW11, SW12, SW13, and SW14 may be controlled by eleventh to fourteenth clock signals CLK11, CLK12, CLK13, and CLK14, respectively.

The first operational amplifier AMP1 may include first and second input nodes 1+ and 1- and an output node 13 and buffer an input voltage Vin and remove an offset voltage of the first operational amplifier AMP1 to output an output voltage Vout.

A first electrode of the first capacitor Cs1 may be connected to the eleventh switch SW11 and the thirteenth switch SW13, and a second electrode of the first capacitor Cs1 may be connected to the second input node 1- of the first operational amplifier AMP1. The first capacitor Cs1 may sample and store the offset voltage of the first operational amplifier AMP1 during a sampling period of the first operational amplifier AMP1 and may hold the offset voltage during a holding period of the first operational amplifier AMP1.

The eleventh switch SW11 may selectively connect the input terminal 12 of the dual buffer circuit 10 and the first electrode of the first capacitor Cs1 in response to the eleventh clock signal CLK11.

The twelfth switch SW12 may selectively connect the output node 13 of the first operational amplifier AMP1 and the second input node 1- in response to the twelfth clock signal CLK12.

The thirteenth switch SW13 may selectively connect the output terminal 14 of the dual buffer circuit 10 and the first electrode of the first capacitor Cs1 in response to the thirteenth clock signal CLK13.

The fourteenth switch SW14 may selectively connect the output node 13 of the first operational amplifier AMP1 and the output terminal 14 of the dual buffer circuit 10 in response to the fourteenth clock signal CLK14.

The second buffer circuit 20-2 may have the same structure as the first buffer circuit 20-1 and may include a second operational amplifier AMP2, twenty-first to twenty-fourth switches SW21, SW22, SW23, and SW24, and a second capacitor Cs2. The twenty-first to twenty-fourth switches SW21, SW22, SW23, and SW24 may be controlled by twenty-first to twenty-fourth clock signals CLK21, CLK22, CLK23, and CLK24, respectively.

The second operational amplifier AMP2 may include first and second input nodes 2+ and 2- and an output node 15 and buffer the input voltage Vin and remove an offset voltage of the second operational amplifier AMP2 to output the output voltage Vout.

A first electrode of the second capacitor Cs2 may be connected to the twenty-first switch SW21 and the twenty-third switch SW23, and a second electrode of the second capacitor Cs2 may be connected to the second input node 2- of the second operational amplifier AMP2. The second capacitor Cs2 may sample and store the offset voltage of the second operational amplifier AMP2 during a sampling period of the second operational amplifier AMP2 and may hold the offset voltage during a holding period of the second operational amplifier AMP2.

The twenty-first switch SW21 may selectively connect the input terminal 12 of the dual buffer circuit 10 and the first electrode of the second capacitor Cs2 in response to the twenty-first clock signal CLK21.

The twenty-second switch SW22 may selectively connect the output node 15 of the second operational amplifier AMP2 and the second input node 2- in response to the twenty-second clock signal CLK22.

The twenty-third switch SW23 may selectively connect the output terminal 14 of the dual buffer circuit 10 and the first electrode of the second capacitor Cs2 in response to the 23rd clock signal CLK23.

The twenty-fourth switch SW24 may selectively connect the output node 15 of the first operational amplifier AMP2 and the output terminal 14 of the dual buffer circuit 10 in response to the twenty-fourth clock signal CLK24.

The first and second buffer circuits 20-1 and 20-2 according to an embodiment may operate in a dual auto-zero mode to remove the offset voltage.

In the dual auto-zero mode, the first buffer circuit 20-1 and the second buffer circuit 20-2 of the dual buffer circuit 10 alternately perform a sampling period in a sampling mode in which offset sampling is performed and a holding period in a holding mode in which offset cancelling is performed such that the constant output voltage Vout can be maintained in a holding state. Details thereof will be described below.

In the first and second buffer circuits 20-1 and 20-2 according to an embodiment, in order to reduce power consumption, only one of the first and second buffer circuits 20-1 and 20-2 may operate in a buffer mode, and the other may be turned off. Details thereof will be described below.

Referring to FIG. 2, a switch controller 30 may receive an auto-zero enable signal AZ_EN and first and second auto-zero clock signals AZ_CLK1 and AZ_CLK2. The switch controller 30 may generate the eleventh to fourteenth clock signals CLK11 to CLK14 and the twenty-first to twenty-fourth clock signals CLK21 to CLK24 and output the clock signals CLK11 to CLK14 and CLK21 to CLK24 to the dual buffer circuit 10.

Referring to FIGS. 2 and 3, the switch controller 30 may generate and output the eleventh to fourteenth clock signals CLK11 to CLK14 using the first auto-zero clock signal AZ_CLK1 and generate and output the twenty-first to twenty-fourth clock signals CLK21 to CLK24 using the second auto-zero clock signal AZ_CLK2, in response to the auto-zero enable signal AZ_EN.

When the auto-zero enable signal AZ_EN is in an enabled (ON) state, the dual buffer circuit 10 may operate in the dual auto-zero mode in response to the eleventh to fourteenth clock signals CLK11 to CLK14 and the twenty-first to twenty-fourth clock signals CLK21 to CLK24.

In response to the enabled (ON) state of the auto-zero enable signal AZ_EN, the switch controller 30 may generate and output the eleventh to fourteenth clock signals CLK11 to CLK14 such that the first buffer circuit 20-1 operates by alternating between a first sampling period and a first holding period using the first auto-zero clock signal AZ_CLK1. The switch controller 30 may generate and output the twenty-first to twenty-fourth clock signals CLK21 to CLK24 such that the second buffer circuit 20-2 operates by alternating between a second holding period and a second sampling period, in an opposite manner to the first buffer circuit 20-1.

The dual buffer circuit 10 may operate in the dual auto-zero mode in which the sampling period, during which the first buffer circuit 20-1 and the second buffer circuit 20-2 perform offset sampling, and the holding period, during which the first buffer circuit 20-1 and the second buffer circuit 20-2 perform offset cancelling, are alternately repeated, in response to the eleventh to fourteenth clock signals CLK11 to CLK14 and the twenty-first to twenty-fourth clock signals CLK21 to CLK24.

In the first sampling period of the first buffer circuit 20-1, the eleventh and twelfth switches SW11 and SW12 may be turned on in response to the eleventh and twelfth clock signals CLK11 and CLK12 and the thirteenth and fourteenth switches SW13 and 14 may be turned off in response to the thirteenth and fourteenth clock signals CLK13 and CLK14. In the first holding period of the first buffer circuit 20-1, the thirteenth and fourteenth switches SW13 and SW14 may be turned on in response to the thirteenth and fourteenth clock signals CLK13 and CLK14 and the eleventh and twelfth switches SW11 and SW12 may be turned off in response to the eleventh and twelfth clock signals CLK11 and CLK12.

In the second holding period of the second buffer circuit 20-1, the twenty-third and twenty-fourth switches SW23 and SW24 may be turned on in response to the twenty-third and twenty-fourth clock signals CLK23 and CLK24 and the twenty-first and twenty-second switches SW21 and SW22 may be turned off in response to the twenty-first and twenty-second clock signals CLK21 and CLK22. In the second sampling period of the second buffer circuit 20-2, the twenty-first and twenty-second switches SW21 and SW22 may be turned on in response to the twenty-first and twenty-second clock signals CLK21 and CLK22 and the twenty-third and twenty-fourth switches SW23 and SW24 may be turned off in response to the twenty-third and twenty-fourth clock signals CLK23 and CLK24.

When the auto-zero enable signal AZ_EN is in a disabled (OFF) state, in the dual buffer circuit 10, only one of the first and second buffer circuits 20-1 and 20-2 may operate in a buffer mode, and the other may be turned off.

In response to the disabled (OFF) state of the auto-zero enable signal AZ_EN, the switch controller 30 may output the eleventh clock signal CLK11 among the eleventh to fourteenth clock signals CLK11 to CLK14 in an OFF state such that the first buffer circuit 20-1 operates in the buffer mode and output the twelfth to fourteenth clock signals CLK12 to CLK14 in an ON state, and output the twenty-first to twenty-fourth clock signals CLK21 to CLK24 in an OFF state such that the operation of the second buffer circuit 20-2 is turned off.

In the buffer mode, in the first buffer circuit 20-1, the twelfth to fourteenth switches SW12, SW13, and SW14 may be turned on in response to the twelfth to fourteenth clock signals CLK12, CLK13, and CLK14 and the eleventh switch SW11 may be turned off in response to the eleventh clock signal CLK11. In the second buffer circuit 20-2, the twenty-first to twenty-fourth switches SW21 to SW24 may be turned off in response to the twenty-first to twenty-fourth clock signals CLK21 to CLK24.

Meanwhile, in response to the disabled (OFF) state of the auto-zero enable signal AZ_EN, the switch controller 30 may generate and output the twenty-first to twenty-fourth clock signals CLK21 to CLK24 such that the second buffer circuit 20-2 operates in the buffer mode, and output the eleventh to fourteenth clock signals CLK11 to CLK14 in the OFF state such that the operation of the first buffer circuit 20-1 is turned off.

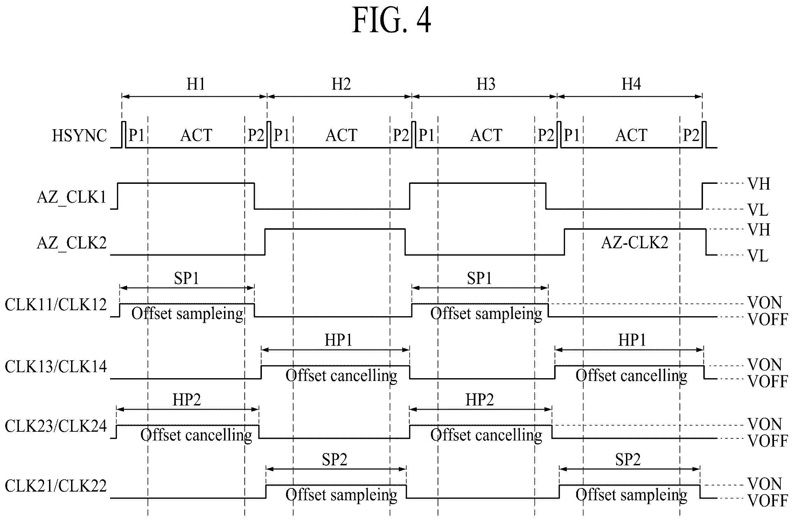

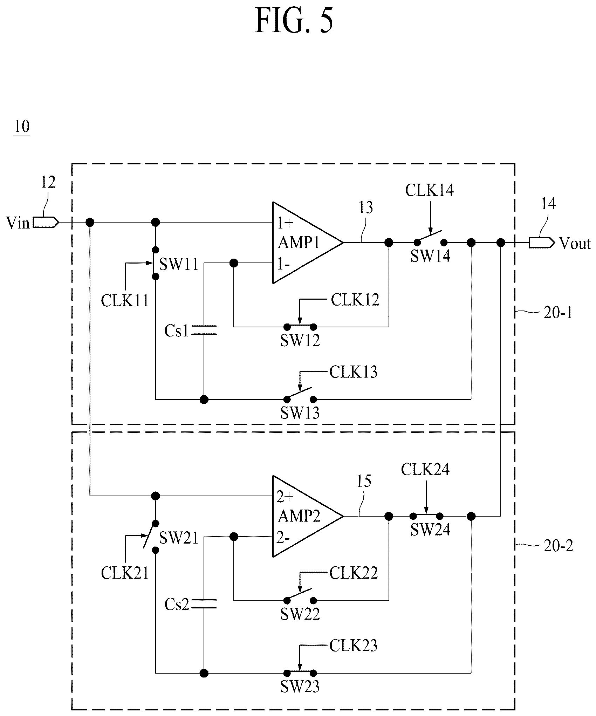

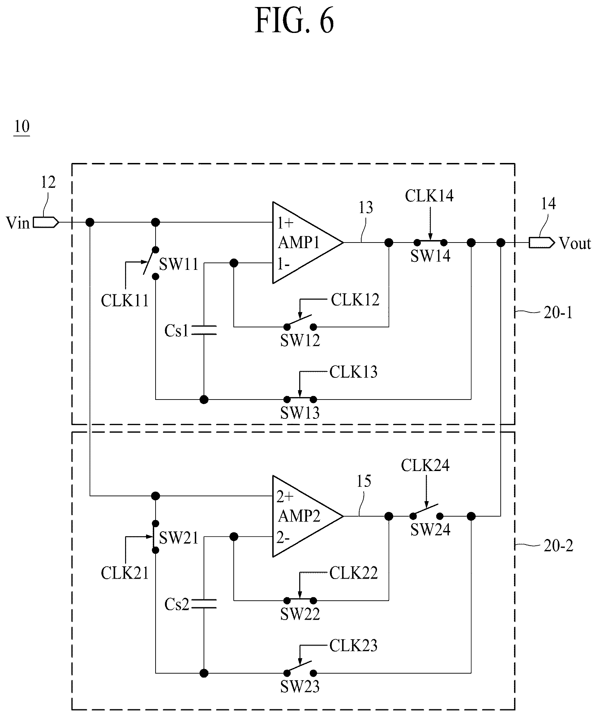

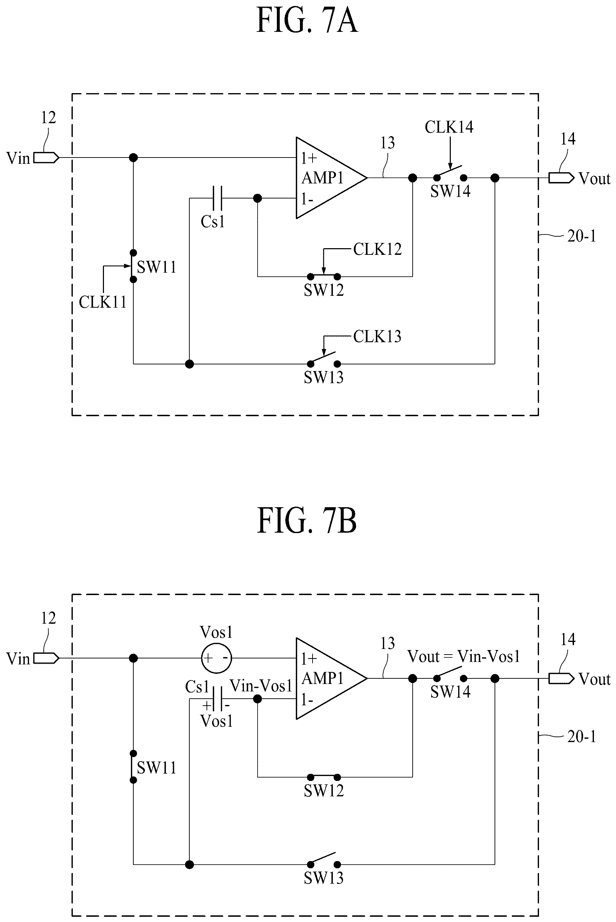

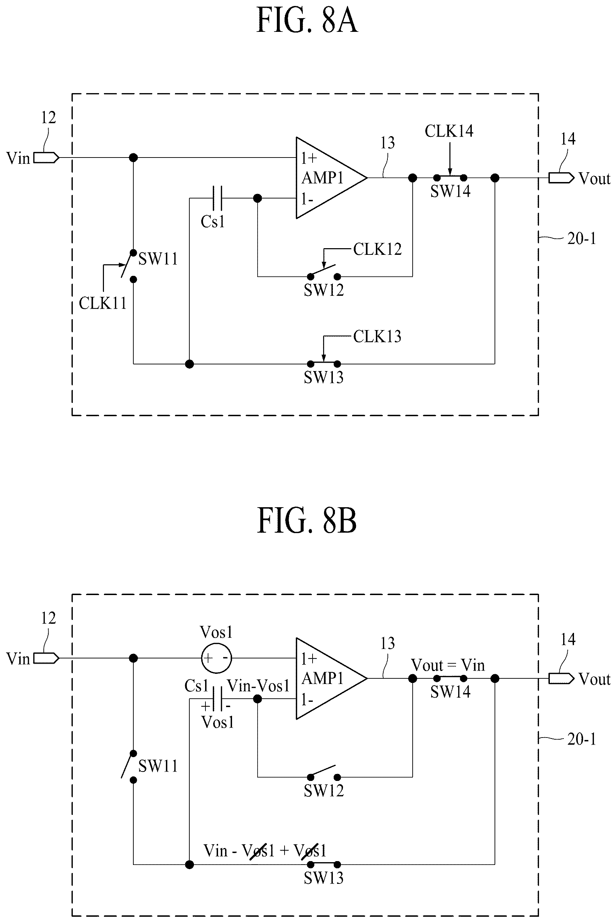

FIG. 4 is an exemplary diagram showing driving waveforms when the dual buffer circuit according to an embodiment illustrated in FIG. 1 operates in a dual auto-zero mode, FIG. 5 is an exemplary diagram showing the operating state of a first horizontal period in the dual auto-zero mode of the dual buffer circuit according to an embodiment illustrated in FIG. 1, FIG. 6 is an exemplary diagram showing the operating state of a second horizontal period in the dual auto-zero mode of the dual buffer circuit according to an embodiment illustrated in FIG. 1, FIGS. 7A and 7B are equivalent circuit diagrams illustrating the operating state of a first sampling period of the first buffer circuit according to an embodiment of the present disclosure, and FIGS. 8A and 8B are equivalent circuit diagrams illustrating the operating state of a first holding period of the first buffer circuit according to an embodiment of the present disclosure.

Referring to FIGS. 2 and 4, the switch controller 30 may receive the auto-zero clock signals AZ_CLK1 and AZ_CLK2 generated based on the timing of a horizontal synchronization signal HSYNC of the display device. Each of the horizontal periods H1, H2, H3, H4, and the like of the horizontal synchronization signal HSYNC may include an active period ACT, and a first blank period P1 and a second blank period P2 before and after the active period ACT.

Each of the first and second auto-zero clock signals AZ_CLK1 and AZ_CLK2 may have a 2H cycle including a high voltage VH for a 1H period and a low voltage VL for a 1H period. The first auto-zero clock signal AZ_CLK1 and the second auto-zero clock signal AZ_CLK2 may have different phases. The high voltage VH periods of the first and second auto-zero clock signals AZ_CLK1 and AZ_CLK2 may not overlap. The low voltage VL periods of the first and second auto-zero clock signals AZ_CLK1 and AZ_CLK2 may partially overlap in the second blank period P2 of each horizontal period.

In the dual buffer circuit 10, the first buffer circuit 20-1 and the second buffer circuit 20-2 may alternately operate in units of 1H between sampling periods SP1 and SP2 for performing offset sampling and holding periods HP1 and HP2 for performing offset cancelling in the dual auto-zero mode.

The eleventh and twelfth clock signals CLK11 and CLK12 may have an on-voltage VON during the first sampling period SP1 of the first buffer circuit 20-1, and the thirteenth and fourteenth clock signals CLK13 and CLK14 may have an on-voltage VON during the first holding period HP1 of the first buffer circuit 20-1. The twenty-first and twenty-second clock signals CLK21 and CLK22 may have an on-voltage VON during the second sampling period SP2 of the second buffer circuit 20-2, and the twenty-third and twenty-fourth clock signals CLK23 and CLK24 may have an on-voltage VON during the second holding period HP2 of the second buffer circuit 20-2.

The first sampling period SP1 of the first buffer circuit 20-1 during which the eleventh and twelfth clock signals CLK11 and CLK12 are in the on-voltage VON state and the first holding period HP1 of the first buffer circuit 20-1 during which the thirteenth and fourteenth clock signals CLK13 and CLK12 are in the on-voltage VON state may not overlap. An off voltage VOFF period of the eleventh and twelfth clock signals CLK11 and CLK12 may partially overlap an off voltage VOFF period of the thirteenth and fourteenth clock signals CLK13 and CLK14 in the second blank period P2 of each horizontal period.

The second sampling period SP2 of the second buffer circuit 20-2 during which the twenty-first and twenty-second clock signals CLK21 and CLK22 are in the on-voltage VON state and the second holding period HP2 of the second buffer circuit 20-2 during which the twenty-third and twenty-fourth clock signals CLK23 and CLK24 are in the on-voltage VON state may not overlap. An off voltage VOFF period of the twenty-first and twenty-second clock signals CLK21 and CLK22 may partially overlap an off voltage VOFF period of the twenty-third and twenty-fourth clock signals CLK23 and CLK24 in the second blank period P2 of each horizontal period.

The first sampling period SP1 of the first buffer circuit 20-1 during which the eleventh and twelfth clock signals CLK11 and CLK12 are in the on-voltage VON state may overlap the second holding period HP2 of the second buffer circuit 20-2 during which the twenty-first and twenty-second clock signals CLK21 and CLK22 are in the on-voltage VON state. The second holding period HP2 of the second buffer circuit 20-2 may have a greater width than the first sampling period SP1 of the first buffer circuit 20-1.

The first holding period HP1 of the first buffer circuit 20-1 during which the thirteenth and fourteenth clock signals CLK13 and CLK14 are in the on-voltage VON state may overlap the second sampling period SP2 of the second buffer circuit 20-2 during which the twenty-first and twenty-second clock signals CLK21 and CLK22 are in the on-voltage VON state. The first holding period HP1 of the first buffer circuit 20-1 may have a greater width than the second sampling period SP2 of the second buffer circuit 20-2.

Referring to FIGS. 4 and 5, during the first horizontal period H1, the first buffer circuit 20-1 may operate in the first sampling period SP1 of the auto-zero mode and the second buffer circuit 20-2 may operate in the second holding period HP2 of the auto-zero mode.

Referring to FIGS. 4, 5, 7A, and 7B, during the first sampling period SP1 of the first buffer circuit 20-1, the eleventh and twelfth switches SW11 and SW12 may be turned ON in response to the eleventh and twelfth clock signals CLK11 and CLK12 and the thirteenth and fourteenth switches SW13 and SW14 may be turned OFF in response to the thirteenth and fourteenth clock signals CLK13 and CLK14. Accordingly, the first capacitor Cs1 of the first buffer circuit 20-1 may sample and store an offset voltage Vos1 of the first operational amplifier AMP1, which is a difference between an input voltage Vin supplied through the eleventh switch SW11 from the input terminal 12 and an output voltage Vout fed back through the twelfth switch SW12.

During the second holding period HP2 of the second buffer circuit 20-2, the twenty-third and twenty-fourth switches SW23 and SW24 may be turned ON in response to the twenty-third and twenty-fourth clock signals CLK23 and CLK24 and the twenty-first and twenty-second switches SW21 and SW22 may be turned OFF in response to the twenty-first and twenty-second clock signals CLK21 and CLK22. Accordingly, an offset voltage Vos2, which is a difference between the input voltage Vin and the output voltage Vout of the second buffer circuit 20-2, may be compensated for (offset) by the offset voltage Vos2 held in the second capacitor Cs2. Therefore, the dual buffer circuit 10 may output an output voltage Vout corresponding to the input voltage Vin from which the offset voltage Vos2 of the second buffer circuit 20-2 is removed.

Referring to FIGS. 4 and 6, during the second horizontal period H2, the first buffer circuit 20-1 may operate in the first holding period HP1 when in the auto-zero mode, and the second buffer circuit 20-2 may operate in an opposite manner to the first horizontal period H1 in the second sampling period SP2 when in the auto-zero mode.

Referring to FIGS. 4, 6, 8A, and 8B, during the first holding period HP1 of the first buffer circuit 20-1, the eleventh and twelfth switches SW11 and SW12 may be turned OFF in response to the eleventh and twelfth clock signals CLK11 and CLK12 and the thirteenth and fourteenth switches SW13 and SW14 may be turned ON in response to the thirteenth and fourteenth clock signals CLK13 and CLK14. Accordingly, the offset voltage Vos1, which is a difference between the input voltage Vin and the output voltage Vout of the first buffer circuit 20-1, may be compensated for (offset) by the offset voltage Vos1 held in the first capacitor Cs1. Therefore, the dual buffer circuit 10 may output an output voltage Vout corresponding to the input voltage Vin from which the offset voltage Vos1 of the first buffer circuit 20-1 is removed.

In the second buffer circuit 20-2, during the second sampling period SP2, the twenty-first and twenty-second switches SW21 and SW22 may be turned ON in response to the twenty-first and twenty-second clock signals CLK21 and CLK22 and the twenty-third and twenty-fourth switches SW23 and SW24 may be turned OFF in response to the twenty-third and twenty-fourth clock signals CLK23 and CLK24. Accordingly, the second capacitor Cs2 of the second buffer circuit 20-2 may sample and store the offset voltage Vos2 of the second operational amplifier AMP2, which is a difference between the input voltage Vin and the output voltage Vout.

In this way, in the dual buffer circuit 10 according to an embodiment of the present disclosure, the first and second buffer circuits 20-1 and 20-2 operate by alternating between the sampling periods SP1 and SP2 and the holding periods HP1 and HP2, respectively, in a repeating manner at least every 1H period such that the constant output voltage Vout may be maintained in a holding state.

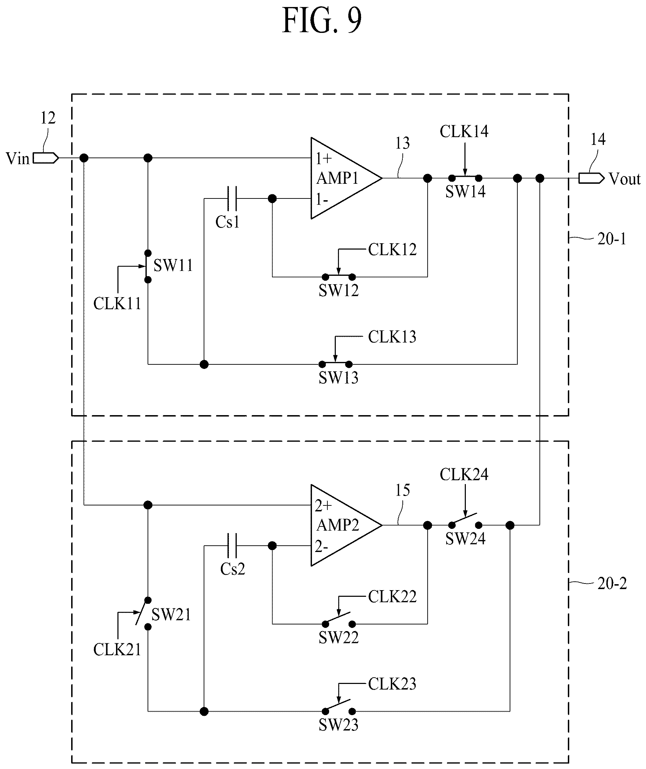

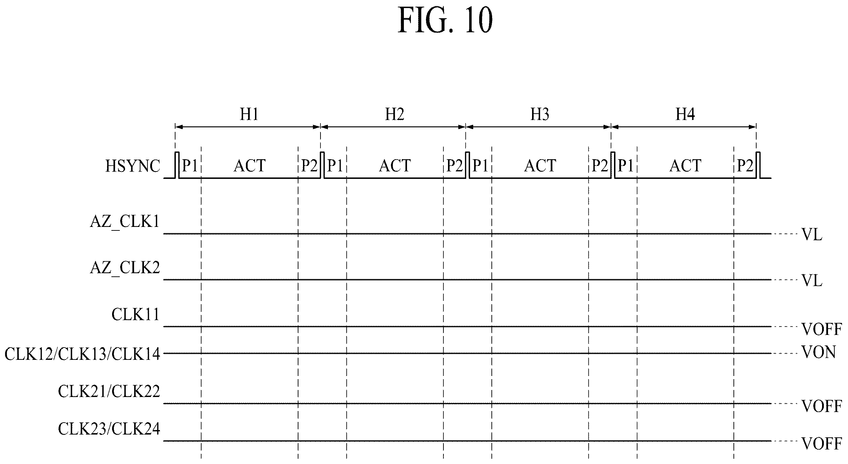

FIG. 9 is an exemplary diagram showing a state in which the dual buffer circuit according to an embodiment of the present disclosure illustrated in FIG. 1 operates in a buffer mode, and FIG. 10 is a diagram illustrating driving waveforms of the dual buffer circuit illustrated in FIG. 9.

When power consumption reduction is required, only one of the first and second buffer circuits 20-1 and 20-2 of the dual buffer circuit 10 according to an embodiment may operate in the buffer mode, and the other may be turned off.

Referring to FIGS. 9 and 10, in the dual buffer circuit 10 according to an embodiment, the first buffer circuit 20-1 may operate in the buffer mode, and the second buffer circuit 20-2 may be turned off.

In response to activated twelfth to fourteenth clock signals CLK12, CLK13, and CLK14, the twelfth to fourteenth switches SW12, SW13, and SW14 of the first buffer circuit 20-1 are turned on, and thus the first buffer circuit 20-1 may operate in the buffer mode. In response to a deactivated eleventh clock signal CLK11, the eleventh switch SW11 may be turned off.

In response to deactivated twenty-first to twenty-fourth clock signals CLK21 to CLK24, the twenty-fourth switches SW21 to SW24 of the second buffer circuit 20-2 are turned off, and thus the second buffer circuit 20-2 may be turned off. Accordingly, the dual buffer circuit 10 may reduce power consumption by half compared to when the first and second buffer circuits 20-1 and 20-2 operate in the dual auto-zero mode.

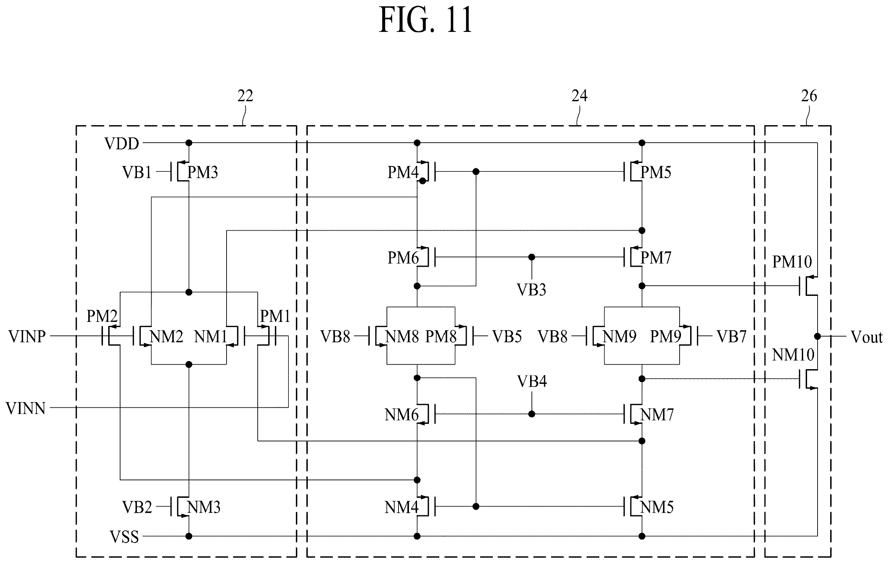

FIG. 11 is an exemplary diagram showing the internal configuration of an operational amplifier according to an embodiment of the present disclosure.

Referring to FIG. 11, a first operational amplifier AMP1 according to an embodiment may include an input stage 22, an amplification stage 24, and an output stage26.

A first input node to which a first input voltage VINP is applied may correspond to the non-inverting input node 1+ of the first operational amplifier AMP1 shown in FIG. 1 and a second input node to which a second input voltage VINN is applied may correspond to the inverting input node 1- of the first operational amplifier AMP1.

The input stage 22 may include PMOS transistors PM1 and PM2 to which the first and second input voltages VINP and VINN are respectively applied, NMOS transistors NM1 and NM2 to which the first and second input voltages VINP and VINN are respectively applied, a PMOS transistor PM3 to which a bias signal VB1 is applied, and an NMOS transistor NM3 to which a bias signal VB2 is applied.

The PMOS transistor PM3 may be connected in series between a first power supply voltage VDD and the PMOS transistors PM1 and PM2 to supply a bias current.

The NMOS transistor NM3 may be connected in series between a second power supply voltage VSS and the NMOS transistors NM1 and NM2 to supply a bias current.

The PMOS transistors PM1 and PM2 may generate a current corresponding to a voltage difference between the first and second input voltages VINP and VINN and provide the current to the amplification stage 24. The NMOS transistors NM1 and NM2 may generate a current corresponding to a voltage difference between the first and second input voltages VINP and VINN and provide the current to the amplification stage 24.

The amplification stage 24 may include a first current mirror composed of PMOS transistors PM4 and PM5, a first cascode circuit composed of PMOS transistors PM6 and PM7, a second current mirror composed of NMOS transistors NM4 and NM5, a second cascode circuit composed of NMOS transistors NM6 and NM7, a third bias circuit composed of PMOS and NMOS transistors PM8 and NM8, and a fourth bias circuit composed of MOS and NMOS transistors PM9 and NM9.

The PMOS transistors PM4 and PM5 of the first current mirror may be connected to the NMOS transistors NM1 and NM2 of the input stage 22, respectively, and may be connected to the PMOS transistors PM6 and PM7 of the first cascode circuit, respectively. The PMOS transistors PM4 and PM5 of the first current mirror may be connected between a supply line of the first power supply voltage VDD and the first cascode circuit.

The PMOS transistors PM6 and PM7 of the first cascode circuit may be controlled by a bias voltage VB3. The PMOS transistor PM7 of the first cascode circuit may be connected to the output stage 26 and may output a first control voltage to a pull-up PMOS transistor PM10 of the output stage 26.

The NMOS transistors NM4 and NM5 of the second current mirror may be connected to the PMOS transistors PM1 and PM2 of the input stage 22, respectively, and may be connected to the NMOS transistors NM6 and NM7 of the second cascode circuit, respectively. The NMOS transistors NM4 and NM5 of the second current mirror may be connected between the second cascode circuit and a supply line of the second power voltage VSS.

The NMOS transistors NM6 and NM7 of the second cascode circuit may be controlled by a bias voltage VB4. The NMOS transistor NM7 of the second cascode circuit may be connected to the output stage 26 and may output a second control voltage to a pull-down NMOS transistor NM10 of the output stage 26.

The PMOS transistor PM8 and the NMOS transistor NM8 of the third bias circuit may be connected between the PMOS transistor PM6 of the first cascode circuit and the NMOS transistor NM6 of the second cascode circuit and may be controlled by fifth and sixth bias voltages VB5 and VB6, respectively, to provide a bias current flowing from the first cascode circuit to the second cascode circuit.

The PMOS transistor PM9 and the NMOS transistor NM9 of the fourth bias circuit may be connected between the PMOS transistor PM7 of the first cascode circuit and the NMOS transistor NM7 of the second cascode circuit and may be controlled by seventh and eighth bias voltages VB7 and VB8, respectively, to provide a bias current flowing from the first cascode circuit to the second cascode circuit.

The output stage 26 may include the pull-up PMOS transistor PM10 and pull-down NMOS transistor NM10 connected to the amplification stage 24.

The pull-up PMOS transistor PM10 may be controlled by the first control voltage output from the PMOS transistor PM7 of the amplification stage 24 and connected between the supply line of the first power supply voltage VDD and the output node. The pull-up PMOS transistor PM10 may perform a pull-up operation according to the first control voltage from the amplification stage 24 to output an output voltage VOUT corresponding to the input voltage VIN.

The pull-down NMOS transistor NM10 may be controlled by the second control voltage output from the NMOS transistor NM7 of the amplification stage 24 and connected between the output node and the second power supply line VSS to perform a pull-down operation. The pull-down NMOS transistor NM10 may perform a pull-down operation according to the second control voltage from the amplification stage 24 to output the output voltage VOUT corresponding to the input voltage VIN.

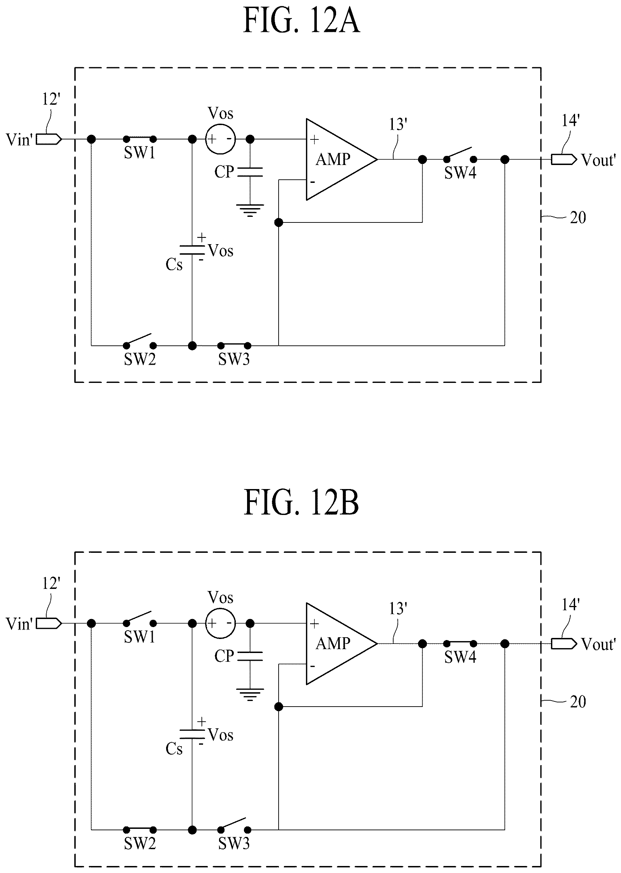

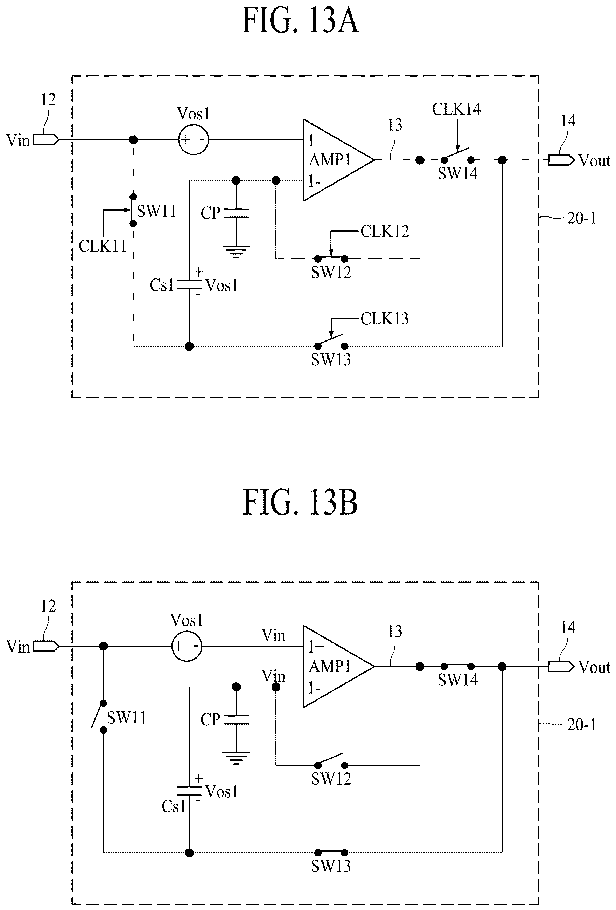

FIGS. 12A and 12B are equivalent circuit diagrams showing the operating states of the sampling period and holding period of a buffer circuit according to a comparative example, and FIGS. 13A and 13B are equivalent circuit diagrams showing the operating states of the sampling period and holding period of the first buffer circuit of the dual buffer circuit according to an embodiment of the present disclosure.

Referring to FIGS. 12A and 12B, a buffer circuit 20 according to the comparative example may include an operational amplifier AMP including a non-inverting input node (+) and an inverting input node (-) and an output node 13', a first switch SW1 connected between an input terminal 12' of the buffer circuit 20 and the non-inverting input node (+) of the operational amplifier AMP and connected to a first electrode of a capacitor Cs, the capacitor Cs whose first electrode is connected to the non-inverting input node (+) of the operational amplifier AMP, a second switch SW2 connected between the input terminal 12' and a second electrode of the capacitor Cs, a third switch SW3 connected between the second electrode of the capacitor Cs and the inverting input node (-) of the operational amplifier AMP, and a fourth switch SW4 connected between the output node 13' of the operational amplifier AMP and an output terminal 14' of the buffer circuit 20.

Referring to FIG. 12A, in the buffer circuit 20 according to the comparative example, the first and third switches SW1 and SW3 are turned on and the second and fourth switches SW2 and SW4 are turned off such that an input voltage Vin' is applied to the non-inverting input node (+) and inverting input node (-) of the operational amplifier AMP, and the capacitor Cs may store an offset voltage Vos of the operational amplifier AMP.

Referring to FIG. 12B, in the buffer circuit 20 according to the comparative example, the first and third switches SW1 and SW3 are turned off and the second and fourth switches SW2 and SW4 are turned on such that an offset voltage -Vos stored in the capacitor Cs and the offset voltage Vos of the operational amplifier AMP are offset and thus an output voltage Vout' corresponding to the input voltage Vin' may be output.

However, in the buffer circuit 20 according to the comparative example, an error component may occur in the offset voltage Vos stored in the capacitor Cs due to charge sharing caused by the parasitic capacitance CP generated by a parasitic capacitor of the non-inverting input node + of the operational amplifier AMP and/or a parasitic capacitor of an input transistor of the operational amplifier AMP. As the parasitic capacitance CP increases, the error component of the offset voltage Vos may increase. As a result, in the buffer circuit 20 according to the comparative example, the output voltage Vout' may be distorted differently from the input voltage Vin' due to the error component of the offset voltage Vos.

On the other hand, referring to FIG. 13A, in the first buffer circuit 20-1 of the dual buffer circuit according to an embodiment of the present disclosure, eleventh and twelfth switches SW11 and SW12 may be turned on and thirteenth and fourteenth switches SW13 and SW14 may be turned off during the sampling period. Accordingly, first and second electrodes of a capacitor Cs1 may be connected between inverting and non-inverting input nodes (1- and 1+) of an first operational amplifier AMP1, an output node 13 of the first operational amplifier AMP1 may be connected to the inverting input node (1-), and the capacitor Cs1 may sample and store an offset voltage Vos1 of the first operational amplifier AMP1.

Referring to FIG. 13B, in the first buffer circuit 20-1 of the dual buffer circuit according to an embodiment of the present disclosure, during the holding period, the eleventh and twelfth switches SW11 and SW12 may be turned off and the thirteenth and fourteenth switches SW13 and SW14 may be turned on. Accordingly, the output node 13 of the first operational amplifier AMP1 and an output terminal 14 of the dual buffer circuit are connected to the inverting input node (1-) via the capacitor Cs1 and the first operational amplifier AMP1 may output an output voltage Vout corresponding to an input voltage Vin by performing a buffering operation. In this case, the offset voltage Vos1 of the first operational amplifier AMP1, which is a difference between the input voltage Vin and the output voltage Vout, may be offset by an offset voltage Vos1 held in the capacitor Cs1.

Thus, it can be seen that the first buffer circuit 20-1 of the dual buffer circuit according to an embodiment of the present disclosure has a structure in which the capacitor Cs1 is connected to an inverting input node (1-) connected to a feedback line of the first operational amplifier AMP1.

Accordingly, during the holding period of FIG. 13B, due to the characteristics of the first operational amplifier AMP1, the inverting input node (1-) becomes a virtual short with the non-inverting input node (1+) such that the inverting input node (1-) maintains the same input voltage Vin as the non-inverting input node (1+). Thus, the offset voltage Vos1 stored in the capacitor Cs1 may not be affected by the parasitic capacitance CP connected to the inverting input node (1-).

Therefore, the dual buffer circuit according to an embodiment of the present disclosure may output an output voltage Vout corresponding to the input voltage Vin by removing the offset voltage of the operational amplifier without the influence of parasitic capacitance during the holding period.

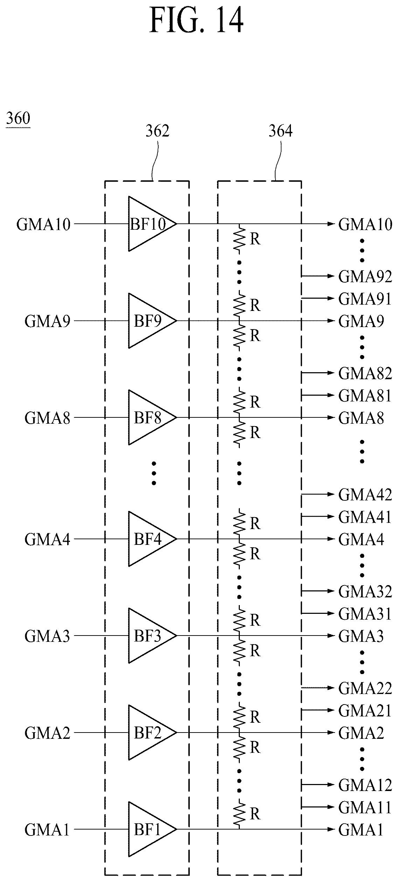

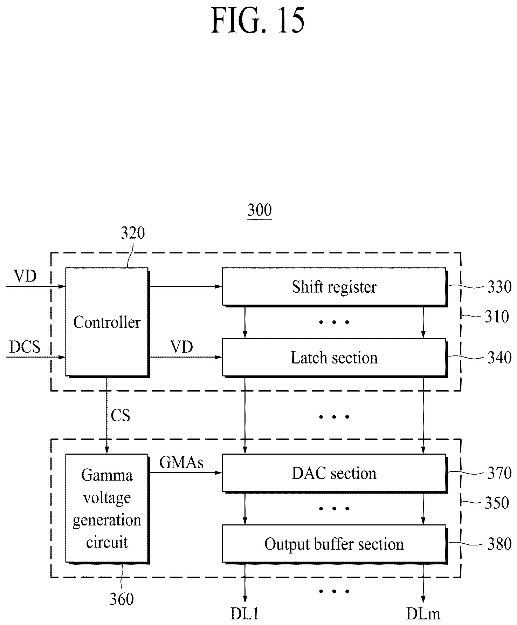

FIG. 14 is an exemplary diagram showing the configuration of a gamma voltage generation circuit according to an embodiment of the present disclosure, and FIG. 15 is an exemplary diagram showing the configuration of a data driver circuit according to an embodiment of the present disclosure.

Referring to FIG. 14, a gamma voltage generation circuit 360 according to an embodiment may include a gamma buffer section 362 and a resistor string 364 and may further include the switch controller 30 according to an embodiment illustrated in FIG. 2.

The gamma buffer section 362 may include a plurality of gamma buffer circuits BGF to BF10 that buffer and output a plurality of reference gamma voltages GMA1 to GMA10, respectively. Each of the plurality of gamma buffer circuits BF1 to BF10 may use the dual buffer circuit 10 according to an embodiment.

The gamma buffer circuits BF1 to BF10 operate in the dual auto-zero mode using the dual buffer circuit 10 according to an embodiment and thereby remove offset voltage and noise components to stably output the output reference gamma voltages GMA1 to GMA10 that respectively correspond to the input reference gamma voltages GMA1 to GMA10, respectively.

The resistor string 364 may divide the plurality of reference gamma voltages GMA1 to GMA10 supplied from the gamma buffer section 362 through resistors R to generate and output a plurality of gamma voltages GMA1, GMA11, GMA12, ..., GMA2, GMA21, GMA22, ..., and GMA10 corresponding to grayscale voltages.

The dual buffer circuit 10 applied to each of the gamma buffer circuits BF1 to BF10 may selectively perform a double auto-zero mode operation and a buffer mode operation in response to the auto-zero enable signal AZ_EN.

For example, in an embodiment, when the data driver circuit and the display device are normally driven, the auto-zero enable signal AZ_EN may be set to an enabled (ON) state. In response to the enabled (ON) state of the auto-zero enable signal AZ_EN, the dual buffer circuit 10 of each of the gamma buffer circuits BF1 to BF10 may operate in the dual auto-zero mode as described above. Accordingly, a reference gamma voltage from which the offset voltage and the noise components are removed can be used, thereby improving reliability.

In an embodiment, during a screen-off period or a period prior to the normal operation of the display device, the auto-zero enable signal AZ_EN may be set to a disabled (OFF) state. In response to the disabled (OFF) state of the auto-zero enable signal AZ_EN, in the dual buffer circuit 10 of each of the gamma buffer circuits BGF to BF10, only one of the first and second buffer circuits 20-1 and 20-2 may operate in the buffer mode, and as a result, power consumption can be reduced.

Referring to FIG. 15, a data driver circuit 300 according to an embodiment may include a digital circuit section 310, which includes a controller 320, a shift register section 330, and a latch section 340, and a analog circuit section 350, which includes a gamma voltage generation circuit 360, a digital-to-analog converter (DAC) section 370, and an output buffer section 380. The data driver circuit 300 may be referred to as a source driver circuit or a display driver circuit.

The controller 320 may receive image data VD and a data control signal DCS, control the shift register 330, the latch section 340, and the gamma voltage generation circuit 360, and supply the image data VD to the latch section 340. The controller 320 may supply the auto-zero enable signal AZ_EN and first and second auto-zero clock signals AZ_CLK1 and AZ_CLK2 to the switch controller 30 of the gamma voltage generation circuit 360 described with reference to FIG. 2.

The shift register 330 may sequentially output a plurality of sampling signals to the latch section 340 while sequentially shifting a source start pulse supplied from the controller 320 according to a source clock signal.

The latch section 340 may latch the image data VD for each channel in subpixel units in response to a plurality of sampling signals sequentially input from the shift register 330 and output the latched image data to the DAC section 370.

The gamma voltage generation circuit 360 may generate a plurality of gamma voltages GMAs in which the plurality of reference gamma voltages GMA1 to GMA10 are subdivided as shown in FIG. 14 and output the generated gamma voltages GMAs to the DAC section 370.

The DAC section 370 may convert digital image data supplied from the latch section 340 into analog data signals using the plurality of gamma voltages GMAs and output the analog data signals to the output buffer section 380.

The output buffer section 380 may buffer the analog data signals supplied from the DAC section 370 for each channel to respectively output the analog data signals to a plurality of data lines DL1 to DLm.

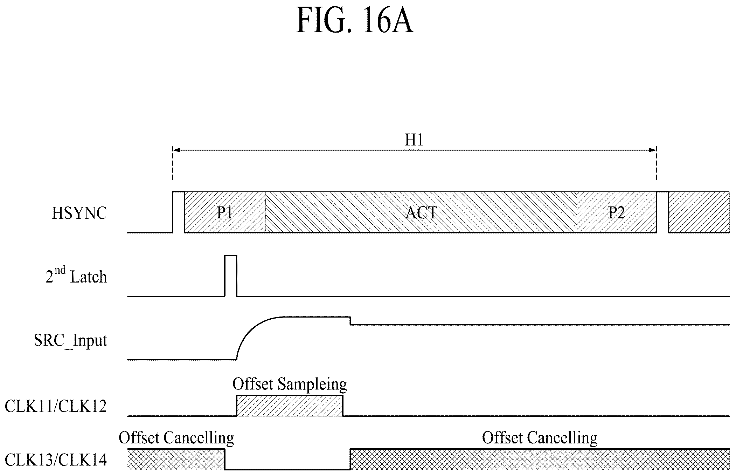

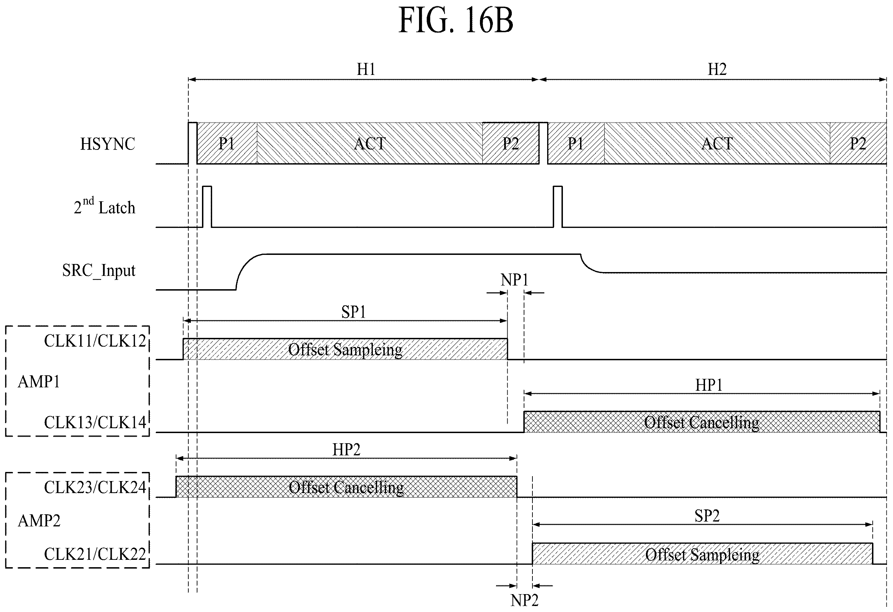

FIGS. 16A and 16B are exemplary diagrams showing the driving waveforms of a data driver circuit using a gamma voltage generation circuit according to a comparative example and an embodiment of the present disclosure.

Referring to FIG. 16A, in the data driver circuit according to the comparative example, a latch section may output latched digital image data to a DAC section in response to a load signal 2^{nd} Latch activated in a first blank period P1 of a period H1. In the data driver circuit according to the comparative example, the gamma voltage generation circuit using a single buffer circuit may output a plurality of gamma voltages to the DAC section through each of a plurality of buffer circuits in the first blank period P1 and may output the plurality of gamma voltages to the DAC section for each horizontal period. Accordingly, the DAC section may convert digital image data into an analog data signal using a plurality of gamma voltages and output the converted analog data signal in the first blank period P1.

However, when using the single buffer circuit in the gamma voltage generation circuit according to the comparative example, it can be seen that both the offset sampling operation and the offset cancelling operation should be performed within the period H1 of the horizontal synchronization signal (HSYNC). Accordingly, it can be seen that an output waveform SRC_Input of the gamma voltage generation circuit is distorted and output in a form in which an offset component remains during the offset sampling period including a portion of the first blank period P1 and a portion of an active period ACT and thus a data signal using the output waveform SRC_Input may also be distorted and output during the offset sampling period.

On the other hand, referring to FIG. 16B, the gamma voltage generation circuit 360 according to an embodiment of the present disclosure uses the dual buffer circuit 10 operating in the dual auto-zero mode according to the above-described embodiment, such that during the period H1, the first buffer circuit 20-1: AZ_AMP1 of the dual buffer circuit 10 may perform an offset sampling operation in the first sampling period SP1 and the second buffer circuit 20-2:AZ_AMP2 may perform an offset canceling operation in the second holding period HP2. During a period H2, the first buffer circuit 20-1:AZ_AMP1 of the dual buffer circuit 10 may perform an offset canceling operation in the first holding period HP1, and the second buffer circuit 20-2:AZ_AMP2 may perform an offset sampling operation in the second sampling period SP2.

Accordingly, it can be seen that the constant output waveform SRC_Input of the gamma voltage generation circuit 360 may be maintained during the active period ACT of each horizontal period compared to the comparative example of FIG. 16A, and as a result, a constant data signal using a gamma voltage may also be output during the active period ACT.

Referring to FIG. 16B, the first sampling period SP1 of the first buffer circuit 20-1: AZ_AMP1 overlapping the period H1 and the first holding period HP1 of the first buffer circuit 20-1: AZ_AMP1 overlapping the period H2 may be separated by a first separation time NP1 in the second blank period P2 of the period H1. The first timing at which the voltage levels of the eleventh and twelfth clock signals CLK11 and CLK12 are switched may be different from the second timing at which the voltage levels of the thirteenth and fourteenth clock signals CLK13 and CLK14 are switched.

The second holding period HP2 of the second buffer circuit 20-2: AZ_AMP2 overlapping the period H1 and the second sampling period SP2 of the second buffer circuit 20-2: AZ_AMP2 overlapping the period H2 may be separated by a second separation time NP2 in the second blank period P2 of the period H1. The third timing at which the voltage levels of the twenty-first and twenty-second clock signals CLK21 and CLK22 are switched may be different from the fourth timing at which the voltage levels of the twenty-third and twenty-fourth clock signals CLK23 and CLK24 are switched.

The first timing at which the voltage levels of the eleventh and twelfth clock signals CLK11 and CLK12 are switched may be different from the third timing at which the voltage levels of the twenty-first and twenty-second clock signals CLK21 and CLK22 are switched. The second timing at which the voltage levels of the thirteenth and fourteenth clock signals CLK13 and CLK14 are switched may be different from the fourth timing at which the voltage levels of the twenty-third and twenty-fourth clock signals CLK23 and CLK24 are switched.

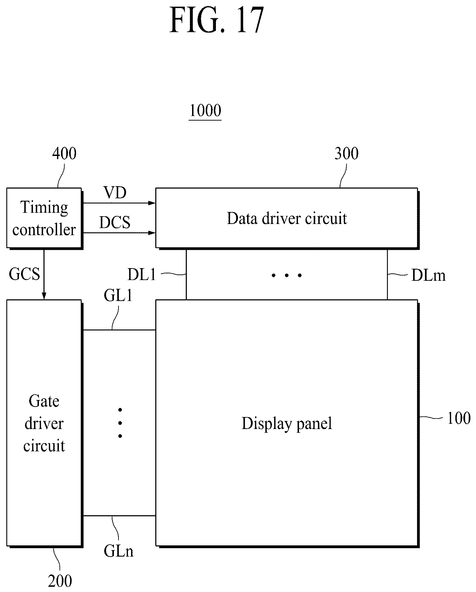

FIG. 17 is an exemplary diagram showing the configuration of a display device according to an embodiment of the present disclosure.

The display device according to an embodiment may be any one of various display devices including a liquid crystal display device, an electroluminescent display device, a micro light emitting diode (LED) display device, etc. The electroluminescent display device may be an organic light emitting diode (OLED) display device, a quantum-dot light emitting diode (QD-LED) display device, or an inorganic light emitting diode (ILED) display device.

Referring to FIG. 17, the display device according to an embodiment may include a display panel 100, a gate driver circuit 200, a data driver circuit 300, a timing controller 400, etc. The gate driver circuit 200, the data driver circuit 300, and the timing controller 400 may be referred to as a display driver circuit.

The display panel 100 displays an image through a display area in which subpixels are arranged in a matrix form. Each subpixel is any one of a red subpixel that emits red light, a green subpixel that emits green light, a blue subpixel that emits blue light, or a white subpixel that emits white light, and is independently driven by at least one thin film transistor (TFT). A unit pixel may be composed of a combination of two, three, or four subpixels of different colors. The subpixels of the display panel 100 may be connected to a plurality of gate lines GL1 to GLn and a plurality of data lines DL1 to DLm.

The display panel 100 may further include a touch sensor screen that entirely overlaps the display area to sense a user's touch, and the touch sensor screen may be built into the display panel 100 or disposed on the display area of the display panel 100.

The timing controller 400 may receive image data and synchronization signals from a host system (not shown). For example, the host system may be any one of a computer, a TV system, a set-top box, and a portable terminal such as a tablet or mobile phone. The synchronization signals may include a dot clock, a data enable signal, a vertical synchronization signal, a horizontal synchronization signal, etc.

The timing controller 400 may generate a plurality of data control signals DCS and supply the data control signals DCS to the data driver circuit 300, and generate a plurality of gate control signals GCS and supply them to the gate driver circuit 200 using the supplied synchronization signals and timing setting information (start timing, pulse width, etc.) stored in an internal register.

The timing controller 400 may perform various types of image processing, such as brightness correction for reducing power consumption or image quality correction, on the supplied image data, and supply the image-processed data VD to the data driver circuit 300.

The gate driver circuit 200 may be controlled according to a plurality of gate control signals GCS supplied from the timing controller 400 to individually drive the gate lines GL1 to GLn of the display panel 100. The gate driver circuit 200 may supply a scan signal of a gate-on voltage to the corresponding gate line during a driving period of each gate line GL, and may supply a gate-off voltage to the corresponding gate line during a non-driving period of each gate line GL.

The gate driver circuit 200 may be formed on a TFT substrate together with the TFT of each subpixel of the display panel 100 and built into a bezel area of the display panel 100.

The data driver circuit 300 may be controlled according to the data control signal DCS supplied from the timing controller 400, and may convert the digital image data VD supplied from the timing controller 400 into an analog data signal and supply the analog data signal to each of the data lines DL1 to DLm of the display panel 100. The data driver circuit 300 may convert digital image data into an analog data signal using gamma voltages generated by the built-in gamma voltage generation circuit 360.

A dual buffer circuit according to an embodiment of the present disclosure operates in a dual auto-zero mode, thereby capable of effectively removing offset voltage and noise components to stably output an output voltage corresponding to an input voltage.

The dual buffer circuit according to an embodiment of the present disclosure can reduce power consumption by having only one of the first and second buffer circuits operate in a buffer mode when necessary.

A gamma voltage generation circuit and a data driver circuit including the dual buffer circuit according to an embodiment can use a reference gamma voltage from which an offset voltage and noise components have been removed through the dual buffer circuit according to an embodiment, thereby improving reliability.

The dual buffer circuit, the gamma voltage generation circuit having the same, and the data driver circuit having the same according to an embodiment of the present disclosure can reduce power consumption by having the dual buffer circuit operate in either a dual auto-zero mode or a buffer mode depending on a specific mode.

A dual buffer circuit according to an embodiment of the present disclosure includes a first buffer circuit that includes a first operational amplifier that is connected between an input terminal and an output terminal and a first capacitor and a first switch section that are connected to the first operational amplifier and a second buffer circuit that includes a second operational amplifier that is connected between the input terminal and the output terminal and a second capacitor and a second switch section that are connected to the second operational amplifier, wherein the first buffer circuit operates by alternating between a first sampling period during which the first offset voltage of the first operational amplifier is sampled and stored in the first capacitor, and a first holding period during which the first offset voltage stored in the first capacitor is held, the second buffer circuit operates by alternating between a second sampling period during which a second offset voltage of the second operational amplifier is sampled and stored in the second capacitor and a second holding period during which the second offset voltage stored in the second capacitor is held, and the first sampling period and the second holding period overlap, and the first holding period and the second sampling period overlap.

In the dual buffer circuit according to an embodiment of the present disclosure, a width of the second holding period may be greater than a width of the first sampling period, and a width of the first holding period may be greater than a width of the second sampling period.

In the dual buffer circuit according to an embodiment of the present disclosure, the first holding period and the second holding period may not overlap, and the first sampling period and the second sampling period may not overlap.

In the dual buffer circuit according to an embodiment of the present disclosure, the first sampling period and the first holding period may not overlap, and the second sampling period and the second holding period may not overlap.

In the dual buffer circuit according to an embodiment of the present disclosure, a first separation time between the first sampling period and the second sampling period may be greater than a second separation time between the first holding period and the second holding period.

In the dual buffer circuit according to an embodiment of the present disclosure, the first buffer circuit may include an eleventh switch connected between a first input node of the first operational amplifier connected to the input terminal and a first electrode of the first capacitor, a twelfth switch connected between a second input node of the first operational amplifier to which a second electrode of the first capacitor is connected and an output node of the first operational amplifier, a thirteenth switch connected between the first electrode of the first capacitor and the output terminal, and a fourteenth switch connected between the output node of the first operational amplifier and the output terminal.

In the dual buffer circuit according to an embodiment of the present disclosure, the second buffer circuit may include a twenty-first switch connected between a first input node of the second operational amplifier connected to the input terminal and a first electrode of the second capacitor, a twenty-second switch connected between a second input node of the second operational amplifier to which a second electrode of the second capacitor is connected and an output node of the second operational amplifier, a twenty-third switch connected between the first electrode of the second capacitor and the output terminal, and a twenty-fourth switch connected between the output node of the second operational amplifier and the output terminal.

In the dual buffer circuit according to an embodiment of the present disclosure, during the first sampling period of the first buffer circuit, the eleventh switch may be turned on in response to an eleventh clock signal, the twelfth switch may be turned on in response to a twelfth clock signal, the thirteenth switch may be turned off in response to a thirteenth clock signal, and the fourteenth switch may be turned off in response to a fourteenth clock signal.

In the dual buffer circuit according to an embodiment of the present disclosure, during the first holding period of the first buffer circuit, the eleventh switch may be turned off in response to the eleventh clock signal, the twelfth switch may be turned off in response to the twelfth clock signal, the thirteenth switch may be turned on in response to the thirteenth clock signal, and the fourteenth switch may be turned on in response to the fourteenth clock signal.

In the dual buffer circuit according to an embodiment of the present disclosure, during the second sampling period of the second buffer circuit, the twenty-first switch may be turned on in response to a twenty-first clock signal, the twenty-second switch may be turned on in response to a twenty-second clock signal, the twenty-third switch may be turned off in response to a twenty-third clock signal, and the twenty-fourth switch may be turned off in response to a twenty-fourth clock signal.

In the dual buffer circuit according to an embodiment of the present disclosure, during the second holding period of the second buffer circuit, the twenty-first switch may be turned off in response to the twenty-first clock signal, the twenty-second switch may be turned off in response to the twenty-second clock signal, the twenty-third switch may be turned on in response to the twenty-third clock signal, and the twenty-fourth switch may be turned on in response to the twenty-fourth clock signal.

In the dual buffer circuit according to an embodiment of the present disclosure, a first timing at which voltage levels of the eleventh and twelfth clock signals are switched may be different from a second timing at which voltage levels of the thirteenth and fourteenth clock signals are switched and a third timing at which voltage levels of the twenty-first and twenty-second clock signals are switched may be different from a fourth timing at which voltage levels of the twenty-third and twenty-fourth clock signals are switched. The first timing may differ from the third timing, and the second timing may differ from the fourth timing.

In the dual buffer circuit according to an embodiment of the present disclosure, a pulse width of a first voltage level of the thirteenth and fourteenth clock signals may be greater than a pulse width of a first voltage level of the eleventh and twelfth clock signals and a pulse width of a first voltage level of the twenty-third and twenty-fourth clock signals may be greater than a pulse width of a first voltage level of the twenty-first and twenty-second clock signals.

The dual buffer circuit according to an embodiment of the present disclosure may further include a switch controller that generates and outputs, in response to an auto-zero enable signal, the eleventh to fourteenth clock signals using a first auto-zero clock signal and generates and outputs the twenty-first to twenty-fourth clock signals using a second auto-zero clock signal.

In the dual buffer circuit according to an embodiment of the present disclosure, in response to an enabled state of the auto-zero enable signal, the dual buffer circuit may operate in an auto-zero mode in which the first buffer circuit operates by alternately repeating the first sampling period and the first holding period, and the second buffer circuit operates in an opposite manner to the first buffer circuit by alternately repeating the second holding period and the second sampling period.

In the dual buffer circuit according to an embodiment of the present disclosure, in response to a disabled state of an auto-zero enable signal, one of the first and second buffer circuits may operate in a buffer mode, and the other may be turned off.

In the dual buffer circuit according to an embodiment of the present disclosure, in response to a disabled state of an auto-zero enable signal, the eleventh switch of the first buffer circuit may be turned off and the twelfth to fourteenth switches may be turned on such that the first buffer circuit may operate in a buffer mode, and the twenty-first to twenty-fourth switches of the second buffer circuit may be turned off.

A gamma voltage generation circuit according to an embodiment of the present disclosure may include a gamma buffer section that includes a plurality of gamma buffers each buffering and outputting a corresponding one of a plurality of reference gamma voltages and a resistor string that divides the plurality of reference gamma voltages output from the gamma buffer section to output a plurality of gamma voltages, wherein each of the plurality of gamma buffers includes the dual buffer circuit.

A data driver circuit according to an embodiment of the present disclosure may include a gamma voltage generation circuit that divides a plurality of reference gamma voltages to output a plurality of gamma voltages and a digital-to-analog converter section that converts digital data into an analog data signal using the plurality of gamma voltages and outputs the converted analog data signal, wherein the gamma voltage generation circuit may include a gamma buffer section including a plurality of gamma buffers each buffering and outputting a corresponding one of the plurality of reference gamma voltages, and a resistor string that divides the plurality of reference gamma voltages output from the gamma buffer section to output the plurality of gamma voltages and each of the plurality of gamma buffers includes the dual buffer circuit.

Those skilled in the art will appreciate that the present disclosure described above may be implemented in other specific forms without changing the technical idea or essential features thereof.

Therefore, it should be understood that the embodiments described above are exemplary in all respects and not limiting. The scope of the present disclosure is indicated by the claims set forth below rather than the detailed description above, and all changes or modifications derived from the meaning and scope of the claims and their equivalent concepts should be interpreted as being included in the scope of the present disclosure.

## Claims

1. A dual buffer circuit comprising:
a first buffer circuit including a first operational amplifier, a first capacitor and at least two first switches connected to the first operational amplifier; and
a second buffer circuit including a second operational amplifier, a second capacitor and at least two second switches connected to the second operational amplifier,
wherein the first buffer circuit is configured to alternate between a first sampling period to sample and store a first offset voltage of the first operational amplifier in the first capacitor, and a first holding period to hold the first offset voltage in the first capacitor,
wherein the second buffer circuit is configured to alternate between a second sampling period to sample and store a second offset voltage of the second operational amplifier in the second capacitor, and a second holding period to hold the second offset voltage in the second capacitor,
wherein the first sampling period is entirely within the second holding period, and wherein the second sampling period is entirely within the first holding period.

2. The dual buffer circuit of claim 1, wherein the first holding period and the second holding period do not overlap,
wherein the first sampling period and the second sampling period do not overlap,
wherein the first sampling period and the first holding period do not overlap, and
wherein the second sampling period and the second holding period do not overlap.

3. The dual buffer circuit of claim 1 or 2, wherein a duration of the second holding period is greater than a duration of the first sampling period,
wherein a duration of the first holding period is greater than a duration of the second sampling period, and
wherein a first separation time between the first sampling period and the second sampling period is greater than a second separation time between the first holding period and the second holding period.

4. The dual buffer circuit of any one of the preceding claims, wherein the first buffer circuit includes:
an eleventh switch connected between a first input node of the first operational amplifier and a first electrode of the first capacitor;
a twelfth switch connected between a second input node of the first operational amplifier to which a second electrode of the first capacitor is connected and an output node of the first operational amplifier;
a thirteenth switch connected between the first electrode of the first capacitor and an output terminal of the dual buffer circuit; and
a fourteenth switch connected between the output node of the first operational amplifier and the output terminal.

5. The dual buffer circuit of claim 4, wherein the second buffer circuit includes:
a twenty-first switch connected between a first input node of the second operational amplifier and a first electrode of the second capacitor;
a twenty-second switch connected between a second input node of the second operational amplifier to which a second electrode of the second capacitor is connected and an output node of the second operational amplifier;
a twenty-third switch connected between the first electrode of the second capacitor and an output terminal of the dual buffer circuit; and
a twenty-fourth switch connected between the output node of the second operational amplifier and the output terminal.

6. The dual buffer circuit of claim 5, wherein, during the first sampling period of the first buffer circuit,
the eleventh switch is turned on in response to an eleventh clock signal,
the twelfth switch is turned on in response to a twelfth clock signal,
the thirteenth switch is turned off in response to a thirteenth clock signal, and
the fourteenth switch is turned off in response to a fourteenth clock signal,
wherein, during the first holding period of the first buffer circuit,
the eleventh switch is turned off in response to the eleventh clock signal,
the twelfth switch is turned off in response to the twelfth clock signal,
the thirteenth switch is turned on in response to the thirteenth clock signal, and
the fourteenth switch is turned on in response to the fourteenth clock signal.

7. The dual buffer circuit of claim 5 or 6, wherein, during the second sampling period of the second buffer circuit,
the twenty-first switch is turned on in response to a twenty-first clock signal,
the twenty-second switch is turned on in response to a twenty-second clock signal,
the twenty-third switch is turned off in response to a twenty-third clock signal, and
the twenty-fourth switch is turned off in response to a twenty-fourth clock signal,
wherein, during the second holding period of the second buffer circuit,
the twenty-first switch is turned off in response to the twenty-first clock signal,
the twenty-second switch is turned off in response to the twenty-second clock signal,
the twenty-third switch is turned on in response to the twenty-third clock signal, and the twenty-fourth switch is turned on in response to the twenty-fourth clock signal.

8. The dual buffer circuit of claim 7,
wherein a first timing at which voltage levels of the eleventh and twelfth clock signals are switched is different from a second timing at which voltage levels of the thirteenth and fourteenth clock signals are switched,
wherein a third timing at which voltage levels of the twenty-first and twenty-second clock signals are switched is different from a fourth timing at which voltage levels of the twenty-third and twenty-fourth clock signals are switched,
wherein the first timing differs from the third timing, and the second timing differs from the fourth timing,

9. The dual buffer circuit of claim 8, wherein a pulse width of a first voltage level of the thirteenth and fourteenth clock signals is greater than a pulse width of a first voltage level of the eleventh and twelfth clock signals, and
wherein a pulse width of a first voltage level of the twenty-third and twenty-fourth clock signals is greater than a pulse width of a first voltage level of the twenty-first and twenty-second clock signals.

10. The dual buffer circuit of any one of claims 7 to 9, further comprising a switch controller that generates and outputs, in response to an auto-zero enable signal, the eleventh to fourteenth clock signals using a first auto-zero clock signal and generates and outputs the twenty-first to twenty-fourth clock signals using a second auto-zero clock signal.

11. The dual buffer circuit of any one of the preceding claims, wherein, in response to an enabled state of an auto-zero enable signal, the dual buffer circuit operates in an auto-zero mode in which the first buffer circuit operates by alternately repeating the first sampling period and the first holding period and the second buffer circuit operates in an opposite manner to the first buffer circuit by alternately repeating the second holding period and the second sampling period, and

12. The dual buffer circuit of any one of the preceding claims, wherein, in response to a disabled state of an auto-zero enable signal, one of the first and second buffer circuits operates in a buffer mode, and the other is turned off.

13. The dual buffer circuit of claim 7, wherein, in response to a disabled state of an auto-zero enable signal, the eleventh switch of the first buffer circuit is turned off and the twelfth to fourteenth switches are turned on such that the first buffer circuit operates in a buffer mode, and
the twenty-first to twenty-fourth switches of the second buffer circuit are turned off.

14. A gamma voltage generation circuit comprising:
a gamma buffer section including a plurality of gamma buffers configured to buffer and output a plurality of reference gamma voltages; and
a resistor string configured to divide the plurality of reference gamma voltages to output a plurality of gamma voltages,
wherein each of the plurality of gamma buffers includes the dual buffer circuit of any one of claims 1 to 13.

15. A data driver circuit comprising:
a gamma voltage generation circuit configured to divide a plurality of reference gamma voltages to output a plurality of gamma voltages; and
a digital-to-analog converter section configured to convert digital data into an analog data signal using the plurality of gamma voltages and output the analog data signal,
wherein the gamma voltage generation circuit includes:
a gamma buffer section including a plurality of gamma buffers configured to buffer and output the plurality of reference gamma voltages; and
a resistor string configured to divide the plurality of reference gamma voltages output from the gamma buffer section to output the plurality of gamma voltages,
wherein each of the plurality of gamma buffers includes the dual buffer circuit of any one of claims 1 to 13.
